# EUROPEAN PATENT SPECIFICATION

(11) **EP 2 518 586 B1**
(45) Date of publication and mention of the grant of the patent: **20.08.2014**
(21) Application number: 12164814.1
(22) Date of filing: 19.04.2012
(51) Int. Cl.: G06F 1/20

(54) **Cooling system for a portable electronic device**
Kühlsystem für eine tragbare elektronische Vorrichtung
Système de refroidissement pour un dispositif électronique portable

(30) Priority: 25.04.2011 CN 201110103395
(43) Date of publication of application: 31.10.2012
(73) Proprietor: Sunon Electronics (Kunshan) Co., Ltd., Kunshan 215301 Jiangsu (CN)
(72) Inventor: Yin, Tso-Kuo, Linya Dist., KAOHSIUNG TAIWAN R.O.C. (TW)
(74) Representative: Zinsinger, Norbert

(56) References cited:
- US-A1- 2002 133 728
- US-A1- 2008 278 905
- US-A1- 2009 002 939
- US-A1- 2009 168 333

## Description

### 1. Field of the Invention

The present invention relates to a cooling system for a portable electronic device and, more particularly, to a cooling system including a fan that can be temporarily slowed down or stopped while the portable electronic device is in a communication state.

### 2. Description of the Related Art

Portable electronic devices capable of providing mobile communication, such as cell phones, personal digital assistants (PDAs), tablet PC, etc, are liable to generate various heat sources during operation. Normal operation of the portable electronic devices is adversely affected if the operational temperature of the portable electronic devices is too high. A cooling system is mounted in relation to the locations of the heat sources to assure smooth and normal operation of the portable electronic devices, avoiding damage to the portable electronic devices due to overheat.

Taiwan Invention Patent No. I3072621 entitled "COOLING SYSTEM" discloses a cooling system suitable for a portable electronic device (such as a mobile phone or PDA). The cooling system includes an airflow guiding module including at least one fan to dissipate the heat of the heat sources generated during operation of the portable electronic device, assuring normal operation of the portable electronic device.

A further cooling system is disclosed in US 2009/0 002 939 A1, in which a cooling fan speed of an electronic device is regulated depending on ambient noise levels.

US 2002/0 133 728 A1 discloses a method for controlling a cooling system depending on network traffic intensity.

In US 2009/0 168 333 A1, a further cooling method is introduced. In a first mode of operation, an electronic device is cooled depending on its temperature, while in a second mode of operation, the cooling fan speed is set to a fixed limited value to reduce noise. Switching between the modes is done manually.

Although the above cooling system provides an enhanced cooling effect for the portable electronic device, the user generally puts the portable electronic device around his or her ear while communicating with another person through the portable electronic device. The operational noise of the fan adversely affects the communication quality and may even cause discomfort to the ear of the user. Thus, improvement in the quality of communication and utility is required.

### SUMMARY OF THE INVENTION

An objective of the present invention is to provide a cooling system for a portable electronic device, with the cooling system including a fan that can be temporarily slowed down or stopped while the portable electronic device is in a communication state, providing enhanced quality of communication and utility. A cooling system for a portable electronic device according to the present invention includes a detection module, a cooling module, and a central control module. The detection module detects whether the portable electronic device is in a communication state. The detection module generates a communication identification signal when the portable electronic device is in the communication state. The detection module generates a non-communication identification signal when the portable electronic device is not in the communication state (a non-communication state). The cooling module includes a fan and a fan driving unit. The fan driving unit is electrically coupled to the fan. The central control module is electrically coupled to the detection module and the fan driving unit. The central control module receives the communication identification signal or the non-communication identification signal from the detection module and drives the fan to rotate or stop via the fan driving unit according to the said identification signals.

The present invention will become clearer in light of the following detailed description of illustrative embodiments of this invention described in connection with the drawings.

### BRIEF DESCRIPTION OF THE DRAWINGS

The illustrative embodiments may best be described by reference to the accompanying drawings where:
FIG. 1 shows a block diagram of a cooling system for a portable electronic device according to the present invention.
FIG. 2 shows a block diagram of a first embodiment of a detection module of the cooling system for a portable electronic device according to the present invention.
FIG. 3 shows a block diagram of a second embodiment of the detection module of the cooling system for a portable electronic device according to the present invention.
FIG. 4 shows a block diagram of a third embodiment of the detection module of the cooling system for a portable electronic device according to the present invention.
FIG. 5 shows a block diagram of a fourth embodiment of the detection module of the cooling system for a portable electronic device according to the present invention.

All figures are drawn for ease of explanation of the basic teachings of the present invention only; the extensions of the figures with respect to number, position, relationship, and dimensions of the parts to form the preferred embodiments will be explained or will be within the skill of the art after the following teachings of the present invention have been read and understood. Further, the exact dimensions and dimensional proportions to conform to specific force, weight, strength, and similar requirements will likewise be within the skill of the art after the following teachings of the present invention have been read and understood.

### DETAILED DESCRIPTION OF THE INVENTION

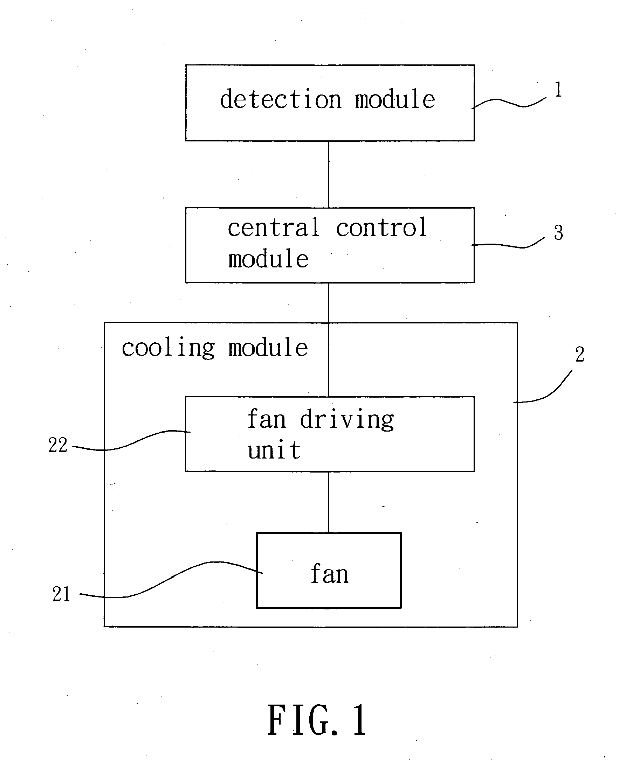

With reference to FIG. 1, a cooling system for a portable electronic device according to the present invention includes a detection module 1, a cooling module 2, and a central control module 3. Both of the detection module 1 and the cooling module 2 are electrically coupled to the central control module 3 by wireless coupling or wires.

The detection module 1 is a module capable of detecting whether the portable electronic device (such as a cell phone, PDA, tablet PC, or the like) is in a communication state. If the detection module 1 determines that the portable electronic device is in the communication state, the detection module 1 sends a communication identification signal to the central control module 3. On the other hand, if the detection module 1 determines that the portable electronic device is not in the communication state, the detection module 1 sends a non-communication identification signal to the central control module 3. When the portable electronic device is in the communication state, the portable electronic device may be transmitting or receiving information such as audio data, text messages or photos. As an example, the portable electronic device is in the communication state when a user is conversing through the portable electronic device or transmitting/receiving text messages or photos through the portable electronic device.

The cooling module 2 includes a fan 21 and a fan driving unit 22. The fan 21 can be an axial fan, a blower fan, or a fan allowing air currents to enter and exit in a direction perpendicular to an axial direction of the fan, generating air convection to provide a cooling effect. Thus, the fan 21 can effectively reduce the temperature of the heat sources generated during operation of the portable electronic device. The fan driving unit 22 is electrically coupled to the central control module 3 and the fan 21. The fan driving unit 22 can drive the fan 21 to rotate in the rated speed of the fan 21 or a low rotational speed, or stop the fan 21. The low rotational speed is slower than the rated speed. The fan driving unit 22 can be mounted inside or outside of the fan 21.

After receiving the communication identification signal or non-communication identification signal from the detection module 1, the fan 21 is driven to rotate or stopped through control of the cooling module 2. Specifically, the fan driving unit 22 drives the fan 21 to rotate when the central control module 3 receives the non-communication identification signal. The fan driving unit 22 stops the fan 21 when the central control module 3 receives the communication identification signal.

The detection module 1 of the cooling system for a portable electronic device according to the present invention can be embodied in various ways, and some of them are illustrated. In the embodiments below, although the portable electronic device is in a conversation mode when the portable electronic device is in the communication state, the communication state of the portable electronic device is not limited to the conversation mode.

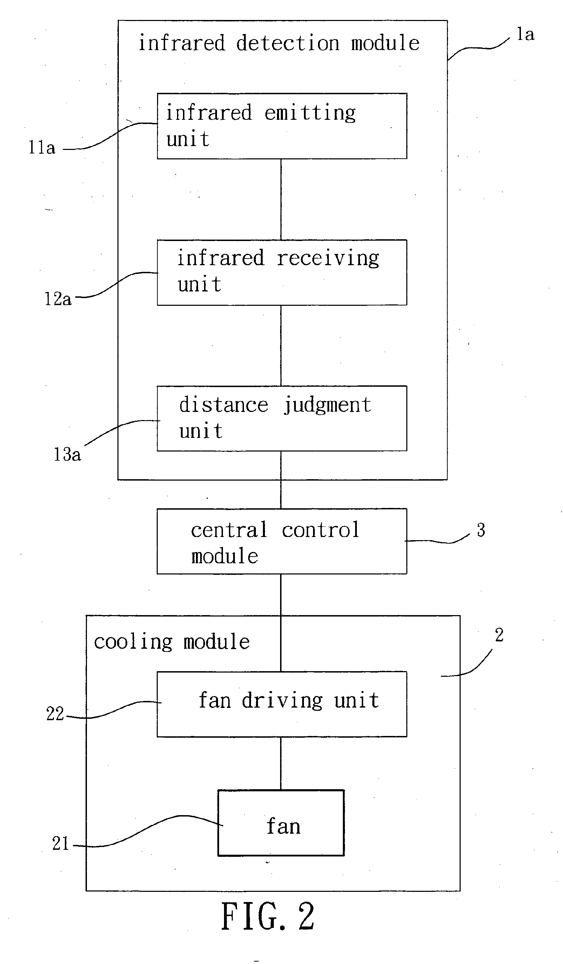

In an embodiment shown in FIG. 2, the detection module is an infrared detection module 1a including an infrared emitting unit 11a, an infrared receiving unit 12a, and a distance judgment unit 13a. The infrared emitting unit 11a emits an infrared ray. The infrared receiving unit 12a receives the infrared ray returned to the infrared detection module 1a. The distance judgment unit 13a calculates a distance between the infrared detection module 1a and a user based on the returned infrared ray.

Specifically, when the user moves the portable electronic device to a location adjacent to his or her face and converses with another person through the portable electronic device, the infrared ray emitted by the infrared emitting unit 11a comes in contact with the face of the user and then returns to the infrared receiving unit 12a. The distance judgment unit 13a calculates the distance between the portable electronic device and the user based on the returned infrared ray received by the infrared receiving unit 12a. If the distance is smaller than a predetermined value (which can be set according to the need of the user), the infrared detection module 1a determines the portable electronic device is in the communication state and sends a communication identification signal to the central control module 3. On the other hand, if the distance is larger than the predetermined value, the infrared detection module 1a determines the portable electronic device is not in the communication state and sends a non-communication identification signal to the central control module 3. The technique of determining a distance by an infrared ray is conventional and, thus, not described in detail. Furthermore, the infrared detection module 1a can only include the infrared emitting unit 11a and the infrared receiving unit 12a without the need of judging the distance. The portable electronic device is determined to be in the communication state if the returned infrared ray is received by the infrared receiving unit 12a. The central control module 3 can determine to start or stop the cooling module 2 upon the communication identification signal or non-communication identification signal from the infrared detection module 1a.

More specifically, the central control module 3 may have a reference rotational speed based on design requirement of the portable electronic device. The reference rotational speed is preferably slower than the rated speed of the fan 21 of the cooling module 2. Therefore, when the infrared detection module 1a sends out the communication identification signal, the central control module 3 can drive the fan 21 of the cooling module 2 to rotate in a rotational speed slower than the reference rotational speed or even stop the cooling module 2. To the contrary, when the infrared detection module 1a sends out the non-communication identification signal, the central control module 3 can drive the fan 21 of the cooling module 2 to rotate in a rotational speed faster than the reference rotational speed. Preferably, the central control module 3 drives the fan 21 of the cooling module 2 to rotate in the rated speed when the infrared detection module 1a sends out the non-communication identification signal.

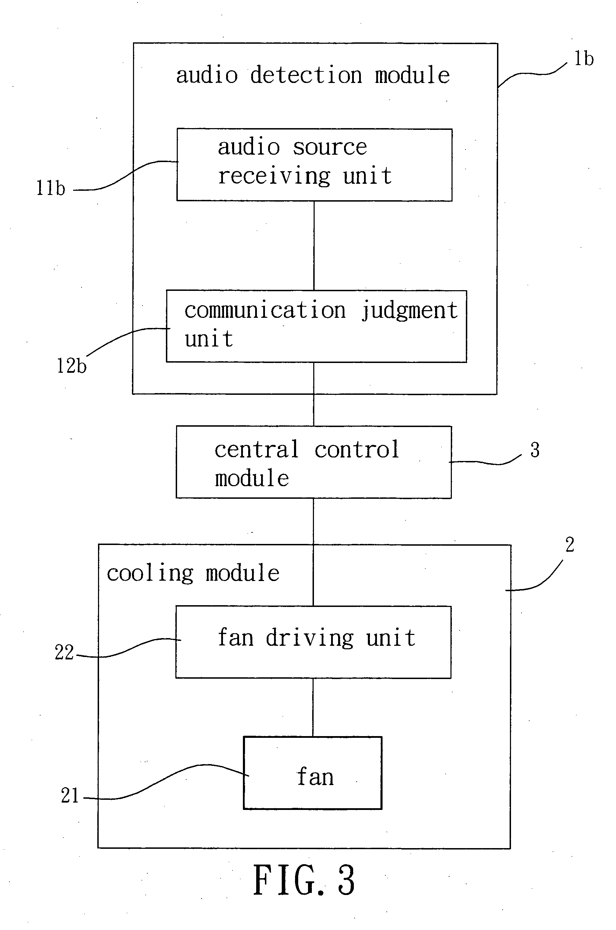

In another embodiment shown in FIG. 3, the detection module is an audio detection module 1b including an audio source receiving unit 11b and a communication judgment unit 12b. The audio source receiving unit 11b is adapted to receive an audio source (such as a microphone). The communication judgment unit 12b determines whether the audio source received by the audio receiving unit 11b is coming from the conversation through the portable electronic device.

Specifically, when the user moves the portable electronic device to a location adjacent to his or her face and communicates with another person through the portable electronic device, the audio source receiving unit 11b receives the audio source resulting from the conversation of the user. The communication judgment unit 12b determines the portable electronic device is in the communication state or the non-communication state to generate the communication identification signal or the non-communication identification signal. Furthermore, factors such as the duration and volume of the received audio source can be included while the communication judgment unit 12b is proceeding with the judgment, avoiding misjudgment of the audio detection module 1b. The technique of determining whether the portable electronic device is in a communication state by the received audio source is conventional and, thus, not described in detail. The central control module 3 can determine to start or stop the cooling module 2 upon the communication identification signal or non-communication identification signal from the audio detection module 1b.

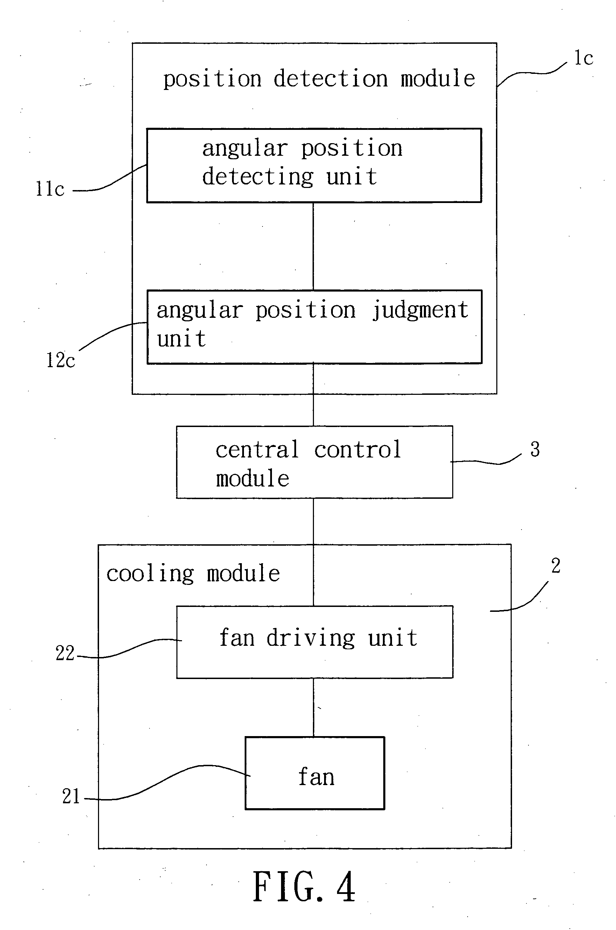

In a further embodiment shown in FIG. 4, the detection module is a position detection module 1c including an angular position detecting unit 11c and an angular position judgment unit 12c. The angular position detecting unit 11c can be a three-axis acceleration detector or any other device capable of detecting a change of an angular position of the portable electronic device. The angular position judgment unit 12c determines whether the portable electronic device in the angular position is in the communication state based on a detection result of the angular position detecting unit 11c.

Specifically, assuming the angular position detecting unit 11c is a three-axis acceleration detector having X, Y, and Z axes, with each axis having two opposite directions represented by symbols "+" and "-". Thus, the three-axis acceleration detector provides detection in six directions X+, X-, Y+, Y-, Z+, and Z-. When the user holds and converses through the portable electronic device, the angular position of the portable electronic device is changed, and such a change is detected by the angular position detecting unit 11c. The technique of determining whether the portable electronic device is in a communication state by a three-axis acceleration detector is conventional and, thus, not described in detail. The angular position judgment unit 12c determines whether the portable electronic device is in the communication state based on the change of the angular position detecting unit 11c. A communication identification signal or a non-communicates identification signal is sent out according to the communication state or non-communication state of the portable electronic device. The central control module 3 can determine to start or stop the cooling module 2 upon the communication identification signal or non-communication identification signal from the angular position judgment unit 12c.

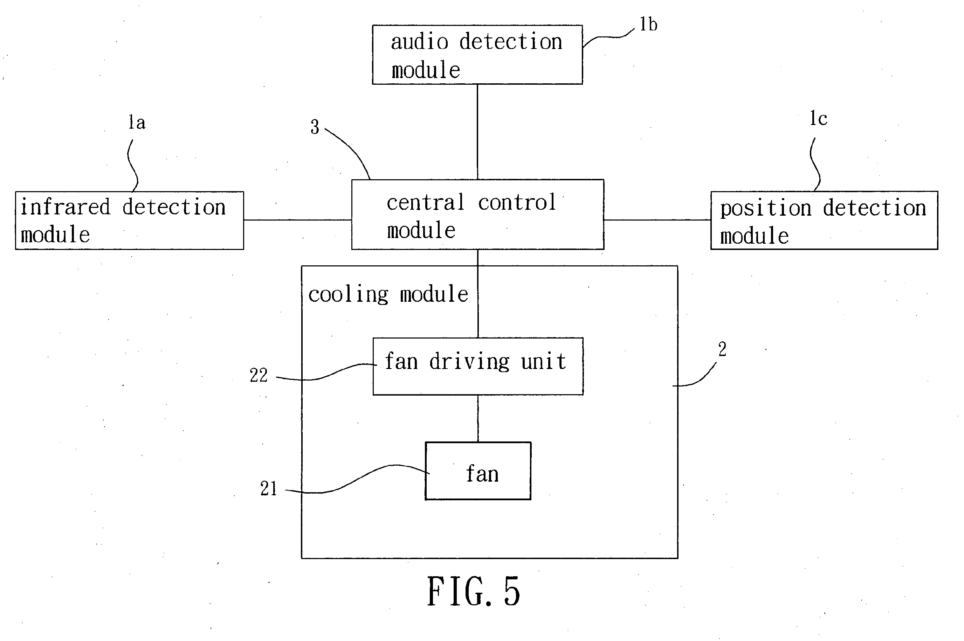

In still another embodiment shown in FIG. 5, the detection module of the cooling system for a portable electronic device is a combination of at least two of the infrared detection module 1a, the audio detection module 1b, and the position detection module 1c. By using plural detection modules, the judgment of whether the portable electronic device is in the communication state or the non-communication state can be more precise.

Furthermore, when the user is conversing through the portable electronic device, the portable electronic device can be placed in a location adjacent to his or her ear. Alternatively, the user can converse through use of an earphone or a Bluetooth. Although determination of the communication state of the portable electronic device covers various use conditions, the quality of communication is scarcely affected when an earphone or a Bluetooth is used. Thus, determination of the communication state of the portable electronic device is carried out according to whether the portable electronic device is adjacent to the ear of the user. This allows normal operation of the cooling module 2 to provide enhanced cooling effect when the user is using an earphone or a Bluetooth for conversation purposes.

In view of the foregoing, the cooling system according to the present invention can be used in various portable electronic devices. The infrared detection module 1a, the audio detection module 1b, and the position detection module 1 c can be used to determine whether the portable electronic device is in the communication state so that the central control module 3 can temporarily stop the fan 21 of the cooling module 2. Thus, adverse affect to the quality of communication and utility resulting from the noise of the fan 21 can be avoided while the user is holding the portable electronic device in a position adjacent to his or her ear for communication purposes. Furthermore, when the user ends the conversation, the central control module 3 restarts the fan 21 of the cooling module 2 to cool the heat sources generated during operation of the portable electronic device, assuring normal operation of the portable electronic device. Overall, the cooling system for a portable electronic device according to the present invention can improve the quality of communication and utility while maintaining better cooling effect.

Thus since the invention disclosed herein may be embodied in other specific forms without departing from the spirit or general characteristics thereof, some of which forms have been indicated, the embodiments described herein are to be considered in all respects illustrative and not restrictive. The scope of the invention is to be indicated by the appended claims, rather than by the foregoing description, and all changes which come within the meaning and range of equivalency of the claims are intended to be embraced therein.

## Claims

1. A cooling system for a portable electronic device comprising:
a detection module (1), with the detection module (1) detecting whether the portable electronic device is in a communication state, in which the portable electronic device is transmitting or receiving information, with the detection module (1) generating a communication identification signal when the portable electronic device is in the communication state, with the detection module (1) generating a non-communication identification signal when the portable electronic device is not in the communication state;
a cooling module (2) including a fan (21) and a fan driving unit (22), with the fan driving unit (22) electrically coupled to the fan (21); and
a central control module (3) electrically coupled to the detection module (1) and the fan driving unit (22), with the central control module (3) receiving the communication identification signal or the non-communication identification signal from the detection module (1) and driving the fan (21) to rotate or stop via the fan driving unit (22) according to the identification signals, **characterized in that** the detection module (1) includes an infrared detection module (1a), with the infrared detection module (1a) including an infrared emitting unit (11a) and an infrared receiving unit (12a), with the infrared emitting unit (11a) emitting an infrared ray, with the infrared receiving unit (12a) receiving the infrared ray returned to the infrared detection module (1a).

2. The cooling system for a portable electronic device as claimed in claim 1, **characterized in that** the infrared detection module (1a) further includes a distance judgment unit (13a), with the distance judgment unit (13a) determining whether the portable electronic device is in the communication state based on the returned infrared ray.

3. The cooling system for a portable electronic device as claimed in claim 2, **characterized in that** the distance judgment unit (13a) calculates a distance based on the returned infrared ray received by the infrared receiving unit (12a), with the distance judgment unit (13a) determining whether the portable electronic device is in the communication state based on the distance.

4. A cooling system for a portable electronic device comprising:
a detection module (1), with the detection module (1) detecting whether the portable electronic device is in a communication state, in which the portable electronic device is transmitting or receiving information, with the detection module (1) generating a communication identification signal when the portable electronic device is in the communication state, with the detection module (1) generating a non-communication identification signal when the portable electronic device is not in the communication state;
a cooling module (2) including a fan (21) and a fan driving unit (22), with the fan driving unit (22) electrically coupled to the fan (21); and a central control module (3) electrically coupled to the detection module (1) and the fan driving unit (22), with the central control module (3) receiving the communication identification signal or the non-communication identification signal from the detection module (1) and driving the fan (21) to rotate or stop via the fan driving unit (22) according to the identification signals, **characterized in that** the detection module (1) includes an audio detection module (1b), with the audio detection module (1b) including an audio source receiving unit (11b) and a communication judgment unit (12b), with the audio source receiving unit (11b) adapted to receive an audio source, with the communication judgment unit (12b) determining whether the audio source received by the audio source receiving unit (11b) is coming from the communication through the portable electronic device.

5. A cooling system for a portable electronic device comprising:
a detection module (1), with the detection module (1) detecting whether the portable electronic device is in a communication state, in which the portable electronic device is transmitting or receiving information, with the detection module (1) generating a communication identification signal when the portable electronic device is in the communication state, with the detection module (1) generating a non-communication identification signal when the portable electronic device is not in the communication state;
a cooling module (2) including a fan (21) and a fan driving unit (22), with the fan driving unit (22) electrically coupled to the fan (21); and a central control module (3) electrically coupled to the detection module (1) and the fan driving unit (22), with the central control module (3) receiving the communication identification signal or the non-communication identification signal from the detection module (1) and driving the fan (21) to rotate or stop via the fan driving unit (22) according to the identification signals,
**characterized in that** the detection module (1) includes a position detection module (1c), with the position detection module (1c) including an angular position detecting unit (11c) and an angular position judgment unit (12c), with the angular position detecting unit (11c) detecting whether an angular position of the portable electronic device is changed, with the angular position judgment unit (12c) determining whether the portable electronic device in the angular position is in the communication state based on a detection result of the angular position detecting unit (11c).

6. The cooling system for a portable electronic device as claimed in claim 5, **characterized in that** the angular position detecting unit (11c) is a three-axis acceleration detector.

7. The cooling system for a portable electronic device as claimed in claim 1, **characterized in that** the central control module (3) includes a reference rotational speed, with the central control module (3) driving the fan (21) of the cooling module (2) to rotate in a rotational speed slower than the reference rotational speed when detecting that the infrared detection module (1a) sends out the communication identification signal, and with the central control module (3) driving the fan (21) of the cooling module (2) to rotate in a rotational speed faster than the reference rotational speed when detecting that the infrared detection module (1a) sends out the non-communication identification signal.

8. The cooling system for a portable electronic device as claimed in claim 7, **characterized in that** the reference rotational speed is slower than a rated speed of the fan (21) of the cooling module (2).

9. The cooling system for a portable electronic device as claimed in claim 1, **characterized in that** the fan (21) is one of an axial fan, a blower fan, and a fan allowing air currents to enter and exit in a direction perpendicular to an axial direction of the fan (21).

10. The cooling system for a portable electronic device as claimed in claim 4, **characterized in that** the fan (21) is one of an axial fan, a blower fan, and a fan allowing air currents to enter and exit in a direction perpendicular to an axial direction of the fan (21).

11. The cooling system for a portable electronic device as claimed in claim 5, **characterized in that** the fan (21) is one of an axial fan, a blower fan, and a fan allowing air currents to enter and exit in a direction perpendicular to an axial direction of the fan (21).

## Patentansprüche

1. Kühlsystem für eine tragbare elektronische Vorrichtung umfassend:
ein Detektionsmodul (1), wobei das Detektionsmodul (1) detektiert, ob die tragbare elektronische Vorrichtung in einem Kommunikationszustand ist, in dem die tragbare elektronische Vorrichtung Informationen übermittelt oder empfängt, wobei das Detektionsmodul (1) ein Kommunikationsidentifikationssignal erzeugt, wenn die tragbare elektronische Vorrichtung in dem Kommunikationszustand ist, wobei das Detektionsmodul (1) ein Nichtkommunikationsidentifikationssignal erzeugt, wenn die tragbare elektronische Vorrichtung nicht in dem Kommunikationszustand ist;
ein Kühlmodul (2) einschließlich eines Lüfters (21) und einer Lüfterantriebseinheit (22), wobei die Lüfterantriebseinheit (22) an den Lüfter (21) elektrisch gekoppelt ist, und
ein zentrales Steuermodul (3), das an das Detektionsmodul (1) und die Lüfterantriebseinheit (22) elektrisch gekoppelt ist, wobei das zentrale Steuermodul (3) das Kommunikationsidentifikationssignal oder das Nichtkommunikationsidentifikationssignal von dem Detektionsmodul (1) empfängt und den Lüfter (21) durch die Lüfterantriebseinheit (22) gemäß dem Identifikationssignal antreibt, sich zu drehen oder anzuhalten, **dadurch gekennzeichnet, dass** das Detektionsmodul (1) ein Infrarotdetektionsmodul (1a) umfasst, wobei das Infrarotdetektionsmodul (1a) eine Infrarotemittereinheit (11a) und eine Infrarotemittereinheit (12a) umfasst, wobei die Infrarotaussendeeinheit (11a) einen Infrarotstrahl emittiert, wobei die Infrarotempfangseinheit (12a) den Infrarotstrahl empfängt, der zu dem Infrarotdetektionsmodul (1a) zurückkommt.

2. Kühlsystem für eine tragbare elektronische Vorrichtung nach Anspruch 1, **dadurch gekennzeichnet, dass** das Infrarotdetektionsmodul (1a) ferner eine Entfernungsbeurteilungseinheit (13a) einschließt, wobei die Entfernungsbeurteilungseinheit (13a) auf der Grundlage des zurückgekehrten Infrarotstrahls bestimmt, ob die tragbare elektronische Vorrichtung in dem Kommunikationszustand ist.

3. Kühlsystem für eine tragbare elektronische Vorrichtung nach Anspruch 2, **dadurch gekennzeichnet, dass** die Entfernungsbeurteilungseinheit (13a) auf der Grundlage des zurückgekehrten Infrarotstrahls, der durch die Infrarotempfangseinheit (12a) empfangen wird, eine Entfernung berechnet, wobei die Entfernungsbeurteilungseinheit (13a) auf der Grundlage der Entfernung bestimmt, ob die tragbare elektronische Vorrichtung in dem Kommunikationszustand ist.

4. Kühlsystem für eine tragbare elektronische Vorrichtung umfassend:
ein Detektionsmodul (1), wobei das Detektionsmodul (1) detektiert, ob die tragbare elektronische Vorrichtung in einem Kommunikationszustand ist, in dem die tragbare elektronische Vorrichtung Informationen übermittelt oder empfängt, wobei das Detektionsmodul (1) ein Kommunikationsidentifikationssignal erzeugt, wenn die tragbare elektronische Vorrichtung in dem Kommunikationszustand ist, wobei das Detektionsmodul (1) ein Nichtkommunikationsidentifikationssignal erzeugt, wenn die tragbare elektronische Vorrichtung nicht in dem Kommunikationszustand ist;
ein Kühlmodul (2) einschließlich eines Lüfters (21) und einer Lüfterantriebseinheit (22), wobei die Lüfterantriebseinheit (22) an den Lüfter (21) elektrisch gekoppelt ist, und ein zentrales Steuermodul (3), das an das Detektionsmodul (1) und die Lüfterantriebseinheit (22) elektrisch gekoppelt ist, wobei das zentrale Steuermodul (3) das Kommunikationsidentifikationssignal oder das Nichtkommunikationsidentifikationssignal von dem Detektionsmodul (1) empfängt und den Lüfter (21) durch die Lüfterantriebseinheit (22) gemäß dem Identifikationssignal antreibt, sich zu drehen oder anzuhalten, **dadurch gekennzeichnet, dass** das Detektionsmodul (1) ein Audiodetektionsmodul (1b) einschließt, wobei das Audiodetektionsmodul (1b) eine Audioquellenempfangseinheit (11b) und eine Kommunikationsbeurteilungseinheit (12b) einschließt, wobei die Audioquellenempfangseinheit (11b) dafür ausgelegt ist, eine Audioquelle zu empfangen, wobei die Kommunikationsbeurteilungseinheit (12b) bestimmt, ob die Audioquelle, die durch die Audioquellenempfangseinheit (11b) empfangen wird, von der Kommunikation durch die tragbare elektronische Vorrichtung kommt.

5. Kühlsystem für eine tragbare elektronische Vorrichtung umfassend:
ein Detektionsmodul (1), wobei das Detektionsmodul (1) detektiert, ob die tragbare elektronische Vorrichtung in einem Kommunikationszustand ist, in dem die tragbare elektronische Vorrichtung Informationen übermittelt oder empfängt, wobei das Detektionsmodul (1) ein Kommunikationsidentifikationssignal erzeugt, wenn die tragbare elektronische Vorrichtung in dem Kommunikationszustand ist, wobei das Detektionsmodul (1) ein Nichtkommunikationsidentifikationssignal erzeugt, wenn die tragbare elektronische Vorrichtung nicht in dem Kommunikationszustand ist;
ein Kühlmodul (2) einschließlich eines Lüfters (21) und einer Lüfterantriebseinheit (22), wobei die Lüfterantriebseinheit (22) an den Lüfter (21) elektrisch gekoppelt ist, und ein zentrales Steuermodul (3), das an das Detektionsmodul (1) und die Lüfterantriebseinheit (22) elektrisch gekoppelt ist, wobei das zentrale Steuermodul (3) das Kommunikationsidentifikationssignal oder das Nichtkommunikationsidentifikationssignal von dem Detektionsmodul (1) empfängt und den Lüfter (21) durch die Lüfterantriebseinheit (22) gemäß dem Identifikationssignal antreibt, sich zu drehen oder anzuhalten,
**dadurch gekennzeichnet, dass** das Detektionsmodul (1) ein Stellungsdetektionsmodul (1c) einschließt, wobei das Stellungsdetektionsmodul (1c) eine Winkelstellungsdetektionseinheit (11c) und eine Winkelstellungsbeurteilungseinheit (12c) umfasst, wobei die Winkelstellungsdetektionseinheit (11c) detektiert, ob eine Winkelstellung der tragbaren elektronischen Vorrichtung geändert ist, wobei die Winkelstellungsbeurteilungseinheit (12c) auf der Grundlage des Detektionsergebnisses der Winkelstellungsdetektionseinheit (11c) bestimmt, ob die tragbare elektronische Vorrichtung in der Winkelstellung in dem Kommunikationszustand ist.

6. Kühlsystem für eine tragbare elektronische Vorrichtung nach Anspruch 5, **dadurch gekennzeichnet, dass** die Winkelstellungsdetektionseinheit (11c) ein dreiachsiger Beschleunigungsdetektor ist.

7. Kühlsystem für eine tragbare elektronische Vorrichtung nach Anspruch 1, **dadurch gekennzeichnet, dass** das zentrale Steuermodul (3) eine Bezugsdrehgeschwindigkeit einschließt, wobei das zentrale Steuermodul (3) den Lüfter (21) des Kühlmoduls (2) antreibt, sich mit einer Drehgeschwindigkeit zu drehen, die langsamer ist als die Bezugsdrehgeschwindigkeit, wenn es detektiert, dass das Infrarotdetektionsmodul (1a) das Kommunikationsidentifikationssignal aussendet, und wobei das zentrale Steuermodul (3) den Lüfter (21) des Kühlmoduls (2) antreibt, sich mit einer Drehgeschwindigkeit zu drehen, die schneller ist als die Bezugsdrehgeschwindigkeit, wenn es detektiert, dass das Infrarotdetektionsmodul (1a) das Nichtkommunikationsidentifikationssignal aussendet.

8. Kühlsystem für eine tragbare elektronische Vorrichtung nach Anspruch 7, **dadurch gekennzeichnet, dass** die Bezugsdrehgeschwindigkeit langsamer ist als eine Nenngeschwindigkeit des Lüfters (21) des Kühlmoduls (2).

9. Kühlsystem für eine tragbare elektronische Vorrichtung nach Anspruch 1, **dadurch gekennzeichnet, dass** der Lüfter (21) ein Axiallüfter, ein Gebläse oder ein Lüfter, der es erlaubt, dass Luftströme in einer Richtung senkrecht zu einer axialen Richtung des Lüfters (21) ein- und austreten, ist.

10. Kühlsystem für eine tragbare elektronische Vorrichtung nach Anspruch 4, **dadurch gekennzeichnet, dass** der Lüfter (21) ein Axiallüfter, ein Gebläse oder ein Lüfter, der es erlaubt, dass Luftströme in einer Richtung senkrecht zu einer axialen Richtung des Lüfters (21) ein- und austreten, ist.

11. Kühlsystem für eine tragbare elektronische Vorrichtung nach Anspruch 5, **dadurch gekennzeichnet, dass** der Lüfter (21) ein Axiallüfter, ein Gebläse oder ein Lüfter, der es erlaubt, dass Luftströme in einer Richtung senkrecht zu einer axialen Richtung des Lüfters (21) ein- und austreten, ist.

## Revendications

1. Système de refroidissement pour un dispositif électronique portable comprenant :
un module de détection (1), le module de détection (1) détectant si le dispositif électronique portable est dans un état de communication, dans lequel le dispositif électronique portable transmet ou reçoit des informations, le module de détection (1) générant un signal d'identification de communication lorsque le dispositif électronique portable est dans l'état de communication, le module de détection (1) générant un signal d'identification de non-communication lorsque le dispositif électronique portable n'est pas dans l'état de communication ;
un module de refroidissement (2) incluant un ventilateur (21) et une unité d'entraînement de ventilateur (22), l'unité d'entraînement de ventilateur (22) étant couplée électriquement au ventilateur (21) ; et
un module de contrôle central (3) couplé électriquement au module de détection (1) et à l'unité d'entraînement du ventilateur (22), le module de contrôle central (3) recevant le signal d'identification de communication ou le signal d'identification de non-communication du module de détection (1) et entraînant la rotation ou l'arrêt du ventilateur (21) par le biais de l'unité d'entraînement de ventilateur (22) en fonction des signaux d'identification, **caractérisé en ce que** le module de détection (1) inclut un module de détection d'infrarouge (1a), le module de détection d'infrarouge (1a) incluant une unité émettrice d'infrarouge (11a) et une unité réceptrice d'infrarouge (12a), l'unité émettrice d'infrarouge (11a) émettant un rayon infrarouge, l'unité réceptrice d'infrarouge (12a) recevant le rayon infrarouge renvoyé vers le module de détection d'infrarouge (1a).

2. Système de refroidissement pour un dispositif électronique portable selon la revendication 1,
**caractérisé en ce que** le module de détection d'infrarouge (1a) inclut en outre une unité d'estimation de distance (13a), l'unité d'estimation de distance (13a) déterminant si le dispositif électronique portable est dans l'état de communication, sur la base du rayon infrarouge renvoyé.

3. Système de refroidissement pour un dispositif électronique portable selon la revendication 2, **caractérisé en ce que** l'unité d'estimation de distance (13a) calcule une distance sur la base du rayon infrarouge renvoyé reçu par l'unité réceptrice d'infrarouge (12a), l'unité d'estimation de distance (13a) déterminant si le dispositif électronique portable est dans l'état de communication, sur la base de la distance.

4. Système de refroidissement pour un dispositif électronique portable, comprenant :
un module de détection (1), le module de détection (1) détectant si le dispositif électronique portable est dans un état de communication, dans lequel le dispositif électronique portable transmet ou reçoit des informations, le module de détection (1) générant un signal d'identification de communication lorsque le dispositif électronique portable est dans l'état de communication, le module de détection (1) générant un signal d'identification de non-communication lorsque le dispositif électronique portable n'est pas dans l'état de communication ;
un module de refroidissement (2) incluant un ventilateur (21 ) et une unité d'entraînement de ventilateur (22), l'unité d'entraînement de ventilateur (22) étant couplée électriquement au ventilateur (21) ; et un module de contrôle central (3) couplé électriquement au module de détection (1) et à l'unité d'entraînement de ventilateur (22), le module de contrôle central (3) recevant le signal d'identification de communication ou le signal d'identification de non-communication du module de détection (1) et entraînant la rotation ou l'arrêt du ventilateur (21) par le biais de l'unité d'entraînement de ventilateur (22) en fonction des signaux d'identification, **caractérisé en ce que** le module de détection (1) inclut un module de détection d'audio (1b), le module de détection d'audio (1b) incluant une unité réceptrice de source audio (11b) et une unité d'estimation de communication (12b), l'unité réceptrice de source audio (11b) étant conçue pour recevoir une source audio, l'unité d'estimation de communication (12b) déterminant si la source audio reçue par l'unité réceptrice de source audio (11b) provient de la communication par l'intermédiaire du dispositif électronique portable.

5. Système de refroidissement pour un dispositif électronique portable comprenant :
un module de détection (1), le module de détection (1) détectant si le dispositif électronique portable est dans un état de communication, dans lequel le dispositif électronique portable transmet ou reçoit des informations, le module de détection (1) générant un signal d'identification de communication lorsque le dispositif électronique portable est dans l'état de communication, le module de détection (1) générant un signal d'identification de non-communication lorsque le dispositif électronique portable n'est pas dans l'état de communication ;
un module de refroidissement (2) incluant un ventilateur (21) et une unité d'entraînement de ventilateur (22), l'unité d'entraînement de ventilateur (22) étant couplée électriquement au ventilateur (21) ; et un module de contrôle central (3) couplé électriquement au module de détection (1) et à l'unité d'entraînement de ventilateur (22), le module de contrôle central (3) recevant le signal d'identification de communication ou le signal d'identification de non-communication du module de détection (1) et entraînant la rotation ou l'arrêt du ventilateur (21) par le biais de l'unité d'entraînement de ventilateur (22) en fonction des signaux d'identification,
**caractérisé en ce que** le module de détection (1) inclut un module de détection de position (1c), le module de détection de position (1c) incluant une unité de détection de position angulaire (11 c) et une unité d'estimation de position angulaire (12c), l'unité de détection de position angulaire (11c) détectant si une position angulaire du dispositif électronique portable est modifiée, l'unité d'estimation de position angulaire (12c) déterminant si le dispositif électronique portable dans la position angulaire est dans l'état de communication, sur la base d'un résultat de détection de l'unité de détection de position angulaire (11 c).

6. Système de refroidissement pour un dispositif électronique portable selon la revendication 5, **caractérisé en ce que** l'unité de détection de position angulaire (11 c) est un détecteur d'accélération trois axes.

7. Système de refroidissement pour un dispositif électronique portable selon la revendication 1,
**caractérisé en ce que** le module de contrôle central (3) inclut une vitesse de rotation de référence, le module de contrôle central (3) entraînant le ventilateur (21) du module de refroidissement (2) pour qu'il tourne à une vitesse de rotation inférieure à la vitesse de rotation de référence lorsqu'il est détecté que le module de détection d'infrarouge (1a) envoie le signal d'identification de communication, et le module de contrôle central (3) entraînant le ventilateur (21) du module de refroidissement (2) pour qu'il tourne à une vitesse de rotation plus rapide que la vitesse de rotation de référence lorsqu'il est détecté que le module de détection d'infrarouge (1a) envoie le signal d'identification de non-communication.

8. Système de refroidissement pour un dispositif électronique portable selon la revendication 7, **caractérisé en ce que** la vitesse de rotation de référence est inférieure à une vitesse nominale du ventilateur (21) du module de refroidissement (2).

9. Système de refroidissement pour un dispositif électronique portable selon la revendication 1, **caractérisé en ce que** le ventilateur (21) est l'un parmi un ventilateur axial, un ventilateur soufflant et un ventilateur permettant à des courants d'air de pénétrer et de sortir dans une direction perpendiculaire à une direction axiale du ventilateur (21).

10. Système de refroidissement pour un dispositif électronique portable selon la revendication 4, **caractérisé en ce que** le ventilateur (21) est l'un parmi un ventilateur axial, un ventilateur soufflant et un ventilateur permettant à des courants d'air de pénétrer et de sortir dans une direction perpendiculaire à une direction axiale du ventilateur (21).

11. Système de refroidissement pour un dispositif électronique portable selon la revendication 5, **caractérisé en ce que** le ventilateur (21) est l'un parmi un ventilateur axial, un ventilateur soufflant et un ventilateur permettant à des courants d'air de pénétrer et de sortir dans une direction perpendiculaire à une direction axiale du ventilateur (21).
